# EUROPÄISCHE PATENTSCHRIFT

(11) **EP 1 927 028 B1**
(45) Veröffentlichungstag und Bekanntmachung des Hinweises auf die Patenterteilung: **09.03.2016**
(21) Anmeldenummer: 06777153.5
(22) Anmeldetag: 02.09.2006
(51) Int. Cl.: G03F 7/00, B41D 7/04

(54) **VORRICHTUNG UND VERFAHREN ZUR HERSTELLUNG EINER NANOSTEMPELSTRUKTUR**
DEVICE AND METHOD FOR THE PRODUCTION OF A STAMP COMPRISING A NANOSTAMPING STRUCTURE
DISPOSITIF ET PROCEDE POUR REALISER UNE MATRICE PRESENTANT UNE NANOSTRUCTURE

(30) Priorität: 14.09.2005 EP 05019943
(43) Veröffentlichungstag der Anmeldung: 04.06.2008
(73) Patentinhaber: Thallner, Erich, 4782 St. Florian (AT)
(72) Erfinder: Thallner, Erich, 4782 St. Florian (AT)
(74) Vertreter: Schweiger, Johannes
(86) Internationale Anmeldenummer: PCT/EP2006/008582
(87) Internationale Veröffentlichungsnummer: WO 2007/031205

(56) Entgegenhaltungen:
- WO-A-02/42844
- WO-A2-02/067055
- US-A1- 2002 167 649
- US-A1- 2003 159 608
- US-A1- 2003 213 382
- US-A1- 2005 038 180
- ISLAM R ET AL: "One micron precision optically aligned method for hot-embossing and nanoirnprinting" PROCEEDINGS OF IEEE SENSORS 2002. ORLANDO, FL, JUNE 12 - 14, 2002, IEEE INTERNATIONAL CONFERENCE ON SENSORS, NEW YORK, NY : IEEE, US, Bd. VOL. 1 OF 2. CONF. 1, 12. Juni 2002 (2002-06-12), Seiten 931-935, XP010605233 ISBN: 0-7803-7454-1
- XIAO PENGFENG ET AL: "Fabrication of microstamps used for oligonucleotide arrays synthesis" PROC SPIE INT SOC OPT ENG; PROCEEDINGS OF SPIE - THE INTERNATIONAL SOCIETY FOR OPTICAL ENGINEERING 2001, Bd. 4601, 2001, Seiten 401-405, XP002380795
- ABAD E ET AL: "Soft lithographic patterning of oxide thin films" PROCEEDINGS OF THE SPIE - THE INTERNATIONAL SOCIETY FOR OPTICAL ENGINEERING SPIE-INT. SOC. OPT. ENG USA, Bd. 5116, 2003, Seiten 176-184, XP002380796 ISSN: 0277-786X
- LIBIOULLE LAURENT ET AL: "Contact-inking stamps for microcontact printing of alkanethiols on gold" LANGMUIR, AMERICAN CHEMICAL SOCIETY, NEW YORK, NY, US, Bd. 15, Nr. 2, 19. Januar 1999 (1999-01-19), Seiten 300-304, XP002215410 ISSN: 0743-7463
- XIA Y ET AL: "SOFT LITHOGRAPHY" ANGEWANDTE CHEMIE. INTERNATIONAL EDITION, WILEY VCH VERLAG, WEINHEIM, DE, Bd. 37, 1998, Seiten 551-575, XP000985399 ISSN: 1433-7851

## Beschreibung

Die Erfindung betrifft eine Vorrichtung und ein Verfahren zur Herstellung eines Stempels, wobei der Stempel einen starren Träger für die Nanostempelstruktur aufweist und die Nanostempelstruktur mit dem Träger verbunden ist, und wobei die Nanostempelstruktur aus erhabenen Strukturen und den erhabenen Strukturen benachbarten Vertiefungen.

In der Halbleiterindustrie ist es notwendig, sehr kleine Strukturen, beispielsweise auf Waferscheiben, Metalle, Kunststoffe oder ähnliche Materialien bzw. Bauteile zu übertragen.

Allgemein bekannter Stand der Technik ist es, diese Strukturen mittels Fotolithographie zu erzeugen. Hierzu werden die Wafer oder die anderen Bauteile mit Fotolack beschichtet und danach durch geeignete Belichtungsgeräte belichtet. In einem darauf folgenden Entwicklungsprozess werden die Strukturen erzeugt.

Eine weitere Möglichkeit, Nanostrukturen zu erzeugen, ist durch sogenannte Direktschreibverfahren mittels E-Beam-Geräten oder Ionenstrahlschreibern gegeben. Auch ist das Erzeugen von Nanostrukturen mittels Röntgenstrahlen bekannt.

Neuere Methoden verwenden zum Aufbringen von Nanostrukturen in Bauteiloberflächen Stempel- oder Prägeverfahren. Bei der sogenannten Stempelmethode werden flexible Stempel aus Poly-Dimethyl-Siloxan (PDMS) verwendet. Solche und ähnliche Technologien sind beispielsweise in den Druckschriften US 2004/0011231 A1, US 5,817,242, US 6,518,189 B1, EP 1 357 433 A2, WO 02/067055 A2, US 2003/159608 A1, US 2005/038180 A1 sowie WO 2003/099463 A3 beschrieben.

TORMEN,M.Sub-µm thick rubber -elastic stamp on rigid support for high reliability microcontact printing.Microelectric Engineering 2002,Vol. 61-62,pages 469-473, ISSN 0167-9317 beschreibt eine Nanostempelstruktur mit starrem Trägermaterial.

Bei den bekannten Prägetechniken ist der maximal mögliche Strukturübertragungsbereich klein. Typischerweise beträgt dieser etwa 625 mm² und ist daher zur Herstellung flächiger großer Bereiche, wie für Datenspeichermedien ungeeignet.

Die WO 02/42844A2 beschreibt einen Stempel zur Einbringung von Strukturen in Bauteile, wobei die Stempelstruktur, die Muster im Mikrometer- und/oder sub-Mikrometerbereich aufweist, direkt mit dem Träger verbunden ist. Der beschriebene Stempel weist Strukturen im Bereich von 1-100 µm auf, die auf Grund der Weichheit des Strukturmaterials, beispielsweise PDMS, und der Stempeldicke eine Abbildung der Stempelstruktur im sub-Mikrometerbereich kaum ermöglichen, da es zu horizontalen Verschiebungen und damit ungenauer Reproduktion der Struktur kommt, Eine Abbildung im sub-Mikrometerbereich ist mit dieser Vorrichtung damit nicht in der geforderten Präzision möglich, insbesondere da die Ebenheit der Waferoberflächen im Nanometerbereich auf Grund von Vorbehandlungsschritten nicht exakt ist.

Der Erfindung liegt daher die Aufgebe zugrunde, eine Vorrichtung und ein Verfahren zur Herstellung eines Stempels vorzuschlagen, mit dem großflächig Nanostrukturen auf Bauteiloberflächen präzise aufgebracht werden können.

Diese Aufgabe wird mit den Merkmalen der Ansprüche 1 und 8 gelöst.

Der Erfindung liegt der Gedanke zugrunde, die Nanostempelstruktur an einen starren Träger zu binden und dabei durch Ausbildung der Vertiefungen möglichst nahe bis zum starren Träger eine Wechselwirkung zwischen benachbarten erhabenen Strukturen weitestgehend zu vermeiden. Dabei sollte auf eine möglichst innige Verbindung zwischen der Nanostempelstruktur und dem Träger geachtet werden. Durch die erfindungsgemäße Ausgestaltung werden horizontal wirkende Kräfte und daraus resultierende Verschiebungen der Stempelstruktur weitestgehend vermieden, so dass eine sehr präzise Abbildung der Stempelstruktur möglich ist.

Anders ausgedrückt werden durch die Maßnahme, die Vertiefungen überwiegend bis zum starren Träger reichend auszubilden flexible Verbindungen zwischen den erhabenen Strukturen weitestgehend ausgeschlossen.

Die präzise Abbildung wird durch eine starke Reduzierung der Stempeldicke, insbesondere des Verhältnisses zwischen Höhe der erhabenen Strukturen und der Gesamthöhe der Nanostempelstruktur, das möglichst klein, vorzugsweise gegen Null gehend, ist.

Im Gegensatz zu den bekannten, flexiblen PDMS-Stempeln ist es mit dem erfindungsgemäßen Stempel mit starrem Träger möglich, Nanostrukturen über eine große Fläche ohne ein sogenanntes "run out" zu realisieren. Der Nachteil der bekannten flexiblen Stempel, sich bei dem Stempelprozess zu verformen, was zu Verzeichnungen und Verzerrungen in der ein-/aufzubringenden Nanostruktur führt, wird mit Vorteil vermieden. Der erfindungsgemäße Stempel eignet sich daher besonders für die Aufbringung von Nanostrukturen für Festplattenspeicherscheiben, für die Flatpanel-Strukturierung sowie für die Aufbringung von Nanostrukturen auf Wafer in sogenannten Full-Wafer-Strukturierungsprozessen. Der erfindungsgemäße Stempel kann jedoch auch für die Aufbringung von Nanostrukturen auf kleinere Flächen, beispielsweise im sogenannten Step- und Repeat-Verfahren, eingesetzt werden.

In Weiterbildung der Erfindung ist mit Vorteil vorgesehen, dass die Nanostempelstruktur des Stempels aus einem ausgehärteten Polymer besteht. Hierfür eignen sich insbesondere Elastomere, bevorzugt Siloxane. Mit Vorteil besteht die Nanostempelstruktur aus ausgehärtetem Poly-Dimethyl-Siloxan (PDMS).

Zur Herstellung einer besonders innigen Verbindung zwischen der Nanostempelstruktur und dem Träger, ist es von entscheidendem Vorteil, wenn der Träger zumindest in einem Teilbereich aus porösem und/oder mit Kanälen durchzogenen Material besteht, wobei eine Porengröße zwischen 10 und 100µm besonders vorteilhaft ist. Bei der Herstellung des Stempels kann das noch flüssige Polymer in die Poren und/oder Kanäle bzw. Kapillaren des Trägers eindringen. Bei der Herstellung des Stempels wird hierzu insbesondere ein Vakuum an den Träger angelegt, um das flüssige Polymer definiert aufzusaugen. Nach dem Aushärten des Polymers ist die Nanostruktur fest in dem Träger verwurzelt. Es ist auch denkbar, zusätzlich oder Alternativ, das flüssige Polymer mittels Überdruck in die Poren bzw. Kanäle "hineinzudrücken". Ein weiterer wesentlicher Vorteil der speziellen Ausgestaltung des Trägers besteht darin, dass der Träger in einem späteren Stempelprozess mit eindiffundierenden Substanzen, wie beispielsweise Thiolen oder Proteinen, benetzt werden kann. Der poröse bzw. mit Kanälen durchzogene Träger saugt sich mit diesen Substanzen voll und gibt diese über die Nanostempelstruktur beim Stempelprozess auf das zu strukturierende Substrat, beispielsweise Edelmetall, ab. Die Notwendigkeit einer Benetzung vor jedem Stempelprozess entfällt somit. Der Träger bildet einen Speicher für diese Substanzen.

Als Materialien zur Herstellung des Trägers eignen sich insbesondere Keramikmaterialien mit sehr kleiner Korngröße. Mit Vorteil handelt es sich um gesintertes Keramikmaterial.

Um den erfindungsgemäßen Stempel zu dem zu strukturierenden Substrat genau justieren zu können, sind Justierungsmittel vorgesehen.

Die Justierungsmittel sind auf der der Nanostempelstruktur gegenüberliegenden Seite des Trägers angeordnet. Hierdurch wird die Möglichkeit geschaffen, den Stempel von der der Nanostempelstruktur gegenüberliegenden Seite her zu justieren.

Die Justierungsmittel sind als dreidimensionale Justierungsmarken ausgebildet. Die Justierungsmarken werden während der Herstellung der Nanostempelstruktur auf den Träger aufgebracht, wodurch nach einem Vermessungsschritt eine genaue definierte Zuordnung zu der Nanostempelstruktur des Stempels gegeben ist. Zur Justierung des Stempels zu dem zu strukturierenden Substrat eignen sich insbesondere optische oder mechanische Justierungssysteme. Beispielsweise können die Justierungsmarken mechanisch mittels AFM-Nadeln abgetastet werden.

Bevorzugt werden die Justierungsmarken nach dem gleichen Prinzip hergestellt wie die Nanostempelstruktur. Mit Vorteil bestehen die Justierungsmarken aus einem ausgehärteten Polymer, insbesondere einem Elastomer, vorzugsweise einem Siloxan, bevorzugt aus PDMS. Das Material für die Justierungsmarken muss nicht zwingend mit dem Material zur Herstellung der Nanostempelstruktur übereinstimmen.

Die erfindungsgemäße Vorrichtung zur Herstellung des Stempels umfasst erfindungsgemäß ein Aufnahmemittel zur Aufnahme eines starren Trägers. Die Träger sind in der Regel als flache Platten mit zwei gegenüberliegenden, ebenen sowie parallelen Seitenflächen ausgebildet. Die erfindungsgemäße Vorrichtung umfasst ferner mindestens einen relativ zu dem starren Träger bewegbaren Masterstempel mit einer Nanostrukturoberfläche. Des Weiteren ist in Ausgestaltung der Erfindung vorgesehen, dass mindestens ein Aufbringmittel zum Aufbringen eines fließfähigen, aushärtbaren Polymers, insbesondere eines Elastomers, vorzugsweise eines Siloxans, bevorzugt von PDMS auf den Träger und/oder den Masterstempel in die Vorrichtung zu integrieren. Bevorzugt sind die Aufbringmittel als Düsen ausgebildet.

Zunächst wird ein starrer Träger in das Aufnahmemittel eingebracht, bevorzugt eingeschoben oder eingelegt. Daraufhin wird mittels des Aufbringmittels, beispielsweise auf die Oberseite des starren Trägers, das fließfähige Polymer aufgebracht. Daraufhin erfolgt eine Relativbewegung zwischen Masterstempel und Träger in der Art, dass die Nanostrukturoberfläche des Masterstempels in das fließfähige Polymer eintaucht. Hierdurch wird die Nanostruktur des Masterstempels in das fließfähige Polymer übertragen.

Es ist von Vorteil, wenn der Masterstempel und der Träger innerhalb einer gegenüber der Atmosphäre/Umgebung dichten Kammer angeordnet sind, wobei die Kammer eine Umfangswand aufweist. Hierdurch ist es möglich, die Druckverhältnisse innerhalb der Kammer steuern zu können, so dass das Eintauchen des Masterstempels in das flüssige Polymer blasenfrei erfolgt.

In Weiterbildung der Erfindung ist vorgesehen, dass die Seite des Trägers, auf die die Nanostempelstruktur aufgebracht werden soll, parallel zu der Nanostrukturoberfläche des Masterstempels angeordnet ist. Dabei ist es von Vorteil, wenn der Masterstempel oberhalb des starren Trägers angeordnet ist und die Nanostrukturoberfläche des Masterstempels nach unten in Richtung des starren Trägers gerichtet ist. Bei der beschriebenen Konfiguration wird das fließfähige Polymer direkt auf den starren Träger aufgebracht. Der Masterstempel wird relativ zu dem starren Träger bewegt, sodass die Nanostrukturoberfläche des Masterstempels in Kontakt mit dem fließfähigen Polymer kommt.

Bevorzugt erfolgt die Bewegung des Masterstempels innerhalb der Kammer translatorisch auf den Träger zu. Dabei sollte der Masterstempel soweit wie möglich bis an den Träger heran verfahren werden. Hierdurch entsteht eine extrem dünne Polymerschicht, bevorzugt eine PDMS-Schicht. Durch diese Maßnahme wird die Flexibilität der Nanostempelstruktur lediglich durch die erhabene Struktur selbst erhalten und es entstehen keine flexiblen Verbindungen zwischen den erhabenen Strukturen. Die erhabenen Strukturen sind mit dem festen Träger ausschließlich vertikal verbunden. Die Strukturen haben keine flexible Verbindung untereinander. Hierdurch treten Verzerrungen und Verzeichnungen während eines späteren Stempelprozesses nicht mehr auf.

Um die Bewegung des Masterstempels und/oder des Trägers exakt steuern zu können, ist in Ausgestaltung der Erfindung mindestens eine Messeinrichtung zur Messung der Position des Masterstempels und/oder des Trägers vorgesehen. Bevorzugt ist die Messeinrichtung auf der der Nanostrukturoberfläche des Masterstempels abgewandten Seite des Masterstempels angeordnet, wodurch der Abstand des sich bewegenden Masterstempels zur Messeinrichtung kontinuierlich gemessen werden kann.

In Weiterbildung der Erfindung ist mindestens eine erste Vakuumleitung zum Anlegen eines Vakuums an den zumindest in einem Teilbereich aus porösem und/oder mit Kanälen durchzogenen Material bestehenden Träger vorgesehen. Bevorzugt ist die Vakuumleitung derart angeordnet, dass das Vakuum an der dem Masterstempel abgewandten Seite des Trägers anlegbar ist. Durch Anlegen eines Vakuums kann das fließfähige Polymer definiert in die Poren und/oder Kanäle bzw. Kapillaren des Trägers eingesaugt werden. Hierdurch wird zum einen die Dicke der entstehenden Nanostempelstruktur gesteuert. Weiterhin wird über den Einsaugprozess eine innige Verbindung zwischen der auf der Oberfläche des Trägers befindlichen Nanostempelstruktur und dem Träger durch das in den Träger eingedrungene fließfähige Polymer erzeugt. Der Einsaugprozess wird derart gesteuert, dass ein Teil des fließfähigen Polymers auf der Trägeroberfläche verbleibt und von der Nanostrukturoberfläche des Masterstempels geformt wird. Es ist auch denkbar, anstelle oder zusätzlich zu dem Vakuum einen Überdruck auf der Seite des Trägers mit dem fließfähigen Polymer anzulegen, um das fließfähige Polymer in die Poren bzw. Kanäle des Trägers hineinzudrücken.

In Ausgestaltung der Erfindung ist vorgesehen, dass der Masterstempel gegenüber der Umfangswand der Kammer abgedichtet ist und dass mindestens eine zweite Vakuum- und/oder Druckleitung zum Anlegen eines Vakuums oder eines Drucks auf der der Nanostrukturoberfläche gegenüberliegenden Seite des Masterstempels vorgesehen ist. Durch Anlegen eines Vakuums kann der Masterstempel fixiert werden. Durch Anlegen eines Drucks kann der Masterstempel in Richtung des starren Trägers verschoben werden. Der Masterstempel ist quasi als in einem Zylinder (Kammer) bewegbarer Kolben ausgebildet. Durch die gleichmäßige Druckverteilung auf der Masterstempelrückseite wird eine gleichmäßige Bewegung des Masterstempels ohne Verkanten gewährleistet.

Zusätzlich ist in Ausgestaltung der Erfindung vorgesehen, dass mindestens eine dritte Vakuum- und/oder Druckleitung zum Anlegen eines Vakuums oder eines Drucks in einem Bereich zwischen dem Masterstempel und dem Träger vorgesehen ist. Über diese dritte Vakuum- und/oder Druckleitung kann die Bewegung des Masterstempels und/oder des starren Trägers zusätzlich gesteuert werden. Gleichzeitig ist es möglich, über diese dritte Vakuumleitung einen Druck aufzubringen, der das fließfähige Polymer in die Poren bzw. Kanäle des Trägers hinein drückt.

Über die Steuerung der Druckverhältnisse wird ein blasenfreies Eintauchen des Masterstempels in das flüssige Polymer sichergestellt.

Die Vorrichtung umfasst mindestens einen Justierungsmarkenstempel zum Einbringen einer dreidimensionalen Justierungsmarke in die von dem Masterstempel abgewandte Seite des Trägers.

Dabei ist es sinnvoll, wenn der Träger auf den Justierungsmarkenstempel auflegbar ist, der Justierungsmarkenstempel also Teil der Halteeinrichtung für den starren Träger ist.

Bevorzugt ist der Justierungsmarkenstempel als Ring ausgebildet, so dass der Träger gleichmäßig mit einer umlaufenden Fläche auf dem Justierungsmarkenstempel aufliegt. Bevorzugt sind an mehreren definierten und in Umfangsrichtung beabstandeten Stellen des Rings Justierungsmarkenstrukturen vorgesehen. Es ist auch denkbar, den Justierungsmarkenstempel auf den Träger aufzulegen, oder den Träger an den Justierungsmarkenstempel anzupressen.

Mit Vorteil ist mindestens ein zweites Aufbringmittel zum Aufbringen eines fließfähigen, aushärtbaren Polymers, insbesondere eines Elastomers, vorzugsweise eines Siloxans, bevorzugt von PDMS auf den Justierungsmarkenstempel und/oder die von dem Masterstempel abgewandte Seite des Trägers vorgesehen. Es besteht jedoch die Möglichkeit, zur Aufbringung des fließfähigen Polymers zur Herstellung der Nanostempelstruktur sowie zur Aufbringung des fließfähigen aushärtbaren Polymers zur Herstellung der Justierungsmarken das oder die selben Aufbringmittel zu verwenden. Bevorzugt erfolgt die Aufbringung des fließfähigen Polymers auf den Justierungsmarkenstempel vor dem Einlegen des Trägers.

Die chemische Zusammensetzung des Polymers zur Herstellung der Justierungsmarken kann von der chemischen Zusammensetzung zur Herstellung der Nanostempelstruktur abweichen. Es ist zur Herstellung der Justierungsmarken denkbar, fluoreszierende oder färbende oder unter bestimmten physikalischen Umständen sich ändernde Substanzen zu verwenden.

In Weiterbildung der Erfindung ist mindestens eine Aushärteinrichtung, vorzugsweise eine Heizung, zur Aushärtung der Nanostempelstruktur und/oder der dreidimensionalen Justierungsmarken vorgesehen. Je nach verwendetem Material kann anstelle oder zusätzlich einer Heizung beispielsweise eine UV-Leuchteinheit verwendet werden. Mit Vorteil werden die Justierungsmarken und die Nanostempelstruktur gleichzeitig in einem gemeinsamen Aushärtprozess ausgehärtet. Hierdurch wird eine definierte Zuordnung der Justierungsmarken zu der Nanostempelstruktur des Trägers geschaffen.

In Ausgestaltung der Erfindung umfasst die Vorrichtung mindestens eine Heizung, welche auf der der Nanostrukturoberfläche gegenüberliegenden Seite des Masterstempels angeordnet ist. Zusätzlich oder alternativ kann mindestens eine weitere Heizung auf der dem Masterstempel abgewandten Seite des Trägers vorgesehen werden. Insbesondere durch das Vorsehen von zwei Heizungen wird die Aushärtezeit minimiert und ein gleichmäßiger Temperaturverlauf gewährleistet.

Gemäß einer vorteilhaften Weiterbildung der Erfindung ist vorgesehen, dass die Kammer einen ersten Kammerabschnitt für den Masterstempel und einen gegenüber dem ersten Kammerabschnitt abdichtbaren zweiten Kammerabschnitt für den Träger aufweist und dass Mittel zum Öffnen und Schließen der Kammer durch Bewegung mindestens eines Kammerabschnitts vorgesehen sind. Der zweite Kammerabschnitt für den Träger bildet die Halteeinrichtung für den Träger. Nach dem Auseinanderbewegen der beiden Kammerabschnitte kann der fertige Stempel entnommen werden und ein neuer Träger eingelegt werden. Bevorzugt wird der neue Träger auf den Justierungsmarkenstempel aufgelegt, nachdem ein fließfähiges Polymer auf diesen aufgebracht wurde. Daraufhin wird die Kammer geschlossen, woraufhin die Aufbringung des fließfähigen Polymers zur Herstellung der Nanostempelstruktur erfolgt. Gleichzeitig mit dem Aufbringen des fließfähigen Polymers oder danach wird eine Relativbewegung zwischen dem Träger und dem Masterstempel in Lauf gesetzt. Bevorzugt erfolgt gleichzeitig das Einsaugen des fließfähigen Polymers in den porösen oder mit Kanälen durchzogenen Träger. Dabei wird fließfähiges Polymer sowohl von der dem Masterstempel zugewandten Seite des Trägers eingesaugt, als auch von der dem Justierungsmarkenstempel zugewandten Seiten her. Nach Abschluss des Einsaugprozesses erfolgt die Aushärtung des fließfähigen Polymers, bevorzugt mittels zweier Heizungen.

Eine Möglichkeit, den ersten Kammerabschnitt relativ zu dem zweiten Kammerabschnitt zu bewegen, besteht darin, eine Rotationsbewegung zwischen den Kammerabschnitten über ein Schwenkgelenk auszuführen.

Eine weitere Möglichkeit besteht darin, einen Kammerabschnitt translatorisch auf den jeweils anderen Kammerabschnitt zu bzw. von diesem weg zu bewegen. Beispielsweise ist die Bewegung mittels eine Hubzylinders denkbar. Weiterhin können zusätzlich seitliche Führungen vorgesehen werden. Auch ist eine kombinierte rotatorisch-translatorische Bewegung, beispielsweise über eine Viergelenkkinematik, denkbar.

Weiterhin ist Gegenstand der Erfindung ein Verfahren zur Herstellung eines Stempels mit einer Nanostempelstruktur. Gemäß dem erfindungsgemäßen Verfahren ist vorgesehen, dass nach dem Einbringen eines, insbesondere porösen oder mit Kanälen durchzogenen, Trägers in eine Halteeinrichtung ein aushärtbares Polymer, insbesondere ein Elastomer, vorzugsweise ein Siloxan, bevorzugt PDMS auf den starren Träger und/oder die Nanostrukturoberfläche eines Masterstempels aufgebracht wird. Daraufhin wird der Abstand zwischen dem Masterstempel und dem starren Träger verringert, wodurch die Nanostrukturoberfläche des Masterstempels in das fließfähige Polymer eintaucht. In einem späteren Schritt wird das Polymer, bevorzugt mittels einer Heizung, ausgehärtet.

Um eine optimale Verbindung zwischen der aus dem Polymer herzustellenden Nanostempelstruktur und dem Träger zu schaffen, wird in Ausgestaltung der Erfindung ein Vakuum an den Träger angelegt, wodurch eine Teilmenge des Polymers in die Poren bzw. Kanäle des Trägers eingesaugt wird. Zusätzlich oder alternativ kann auch ein Druck angelegt werden, so dass das fließfähige Polymer in die Poren und/oder Kanäle des Trägers hinein gedrückt wird.

Während des Herstellungsverfahrens der Nanostempelstruktur wird in Ausgestaltung der Erfindung auch eine dreidimensionale Justierungsmarke in den Träger, bevorzugt in die dem Masterstempel abgewandte Seite des Trägers, eingebracht.

Diese Justierungsmarke wird bevorzugt ebenfalls aus einem fließfähigen Polymer, insbesondere einem Elastomer, vorzugsweise einem Siloxan, bevorzugt aus PDMS hergestellt. Bevorzugt erfolgt die Aushärtung der Justierungsmarken und der Nanostempelstruktur gleichzeitig, sodass eine definierte Zuordnung zwischen Justierungsmarke und Nanostempelstruktur geschaffen wird.

Die Abscheidung von zu prägenden Stoffen kann sowohl durch die Rückseite des porösen Trägers als auch auf der Vorderseite des Stempels erfolgen, und zwar sowohl aus flüssiger als auch aus dampfförmiger Phase.

Weitere Vorteile und zweckmäßige Ausführungen sind den weiteren Ansprüchen, der Figurenbeschreibung und den Zeichnungen zu entnehmen. Insbesondere wesentliche Verfahrensmerkmale sind der Figurenbeschreibung zu entnehmen. Es zeigen:
- Fig. 1: eine Vorrichtung zur Herstellung eines Stempels mit einer Nanostempelstruktur, mit zwei Kammerabschnitten im geöffneten Zustand,
- Fig. 2: die Vorrichtung gemäß Fig. 1 mit geschlossenen Kammerabschnitten,
- Fig. 3: einen als Ring ausgebildeten Justierungsmarkenstempel mit Justierungsmarkenstrukturen und
- Fig. 4: einen Stempel.

In den Figuren sind gleiche Bauteile sowie Bauteile mit gleicher Funktion mit den gleichen Bezugszeichen versehen.

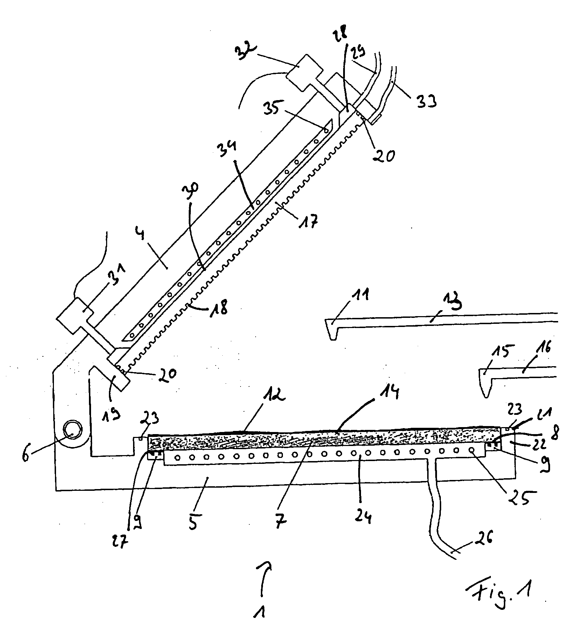

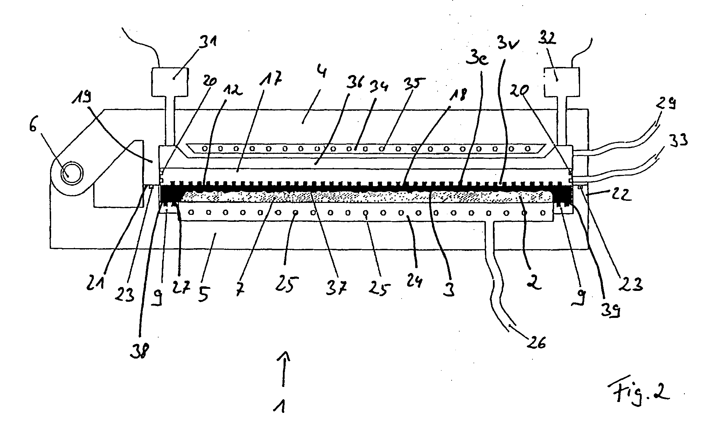

In Fig. 1 ist eine Vorrichtung 1 zur Herstellung eines Stempels 2 mit einer Nanostempelstruktur 3 (siehe Fig. 2) dargestellt, wobei die Nanostempelstruktur 3 erhabene Strukturen 3e und den erhabenen Strukturen 3e benachbarte Vertiefungen 3v aufweist.

Die Vorrichtung 1 weist einen ersten und einen zweiten Kammerabschnitt 4, 5 auf, wobei die beiden Kammerabschnitte 4, 5 gelenkig über ein Schwenkgelenk 6 miteinander verbunden sind. Der untere, zweite Kammerabschnitt 5 ist horizontal ausgerichtet und dient als Halteeinrichtung für einen Träger 7 für die aufzubringende Nanostempelstruktur 3.

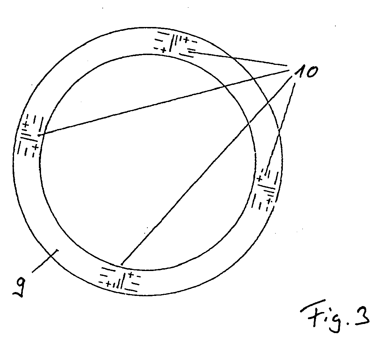

Der Träger 7 liegt mit seinem umlaufenden Randbereich 8 auf einem ringförmigen Justierungsmarkenstempel 9 auf. Der Justierungsmarkenstempel 9 ist in Fig. 3 in einer Draufsicht dargestellt. Wie aus Fig. 3 ersichtlich ist, weist der Justierungsmarkenstempel 9 mehrere über den Umfang verteilte Justierungsmarkenstrukturen 10 zur Einbringung von entsprechenden Justierungsmarken auf den darüber angeordneten Träger 7 auf.

Weiterhin weist die Vorrichtung ein als Düse 11 ausgebildetes erstes Aufbringmittel zur Aufbringung von fließfähigem Poly-Dimethyl-Siloxan (PDMS) 12 auf den porösen Träger 7 auf. Die Düse 11 ist mit einer Zuleitung 13 verbunden. Der Zuleitung 13 ist eine nicht dargestellte Dosiereinrichtung zur dosierten Aufbringung des fließfähigen PDMS auf eine Oberseite 14 des porösen, starren Trägers 7 zugeordnet.

Unterhalb der Düse 11 mit Zuleitung 13 befindet sich ein ebenfalls als Düse 15 ausgebildetes zweites Aufbringmittel zur Aufbringung von PDMS auf die Oberseite des Justierungsmarkenstempels 9. Bei dem gezeigten Ausführungsbeispiel erfolgt die Aufbringung von PDMS 27 auf den Justierungsmarkenstempel 9 vor dem Einlegen des porösen Trägers 7 in den zweiten Kammerabschnitt 5. Die zweite Düse 15 ist mit einer Zuleitung 16 verbunden, die zu einer nicht gezeigten Dosiereinrichtung mit Pumpe führt.

In dem ersten Kammerabschnitt 4 ist ein Masterstempel 17 mit einer Nanostrukturoberfläche 18 angeordnet. Der Masterstempel 17 ist gegenüber einer Umfangswand 19 des ersten Kammerabschnitts 4 mittels zweier übereinander angeordneter O-Ringe 20 abgedichtet. Die O-Ringe 20 sind derart beschaffen, dass der Masterstempel 17 entlang der Umfangswand 19 translatorisch bewegt werden kann.

Auf der Oberseite 21 einer Umfangswand 22 des zweiten Kammerabschnitts ist eine umlaufende Ringdichtung 23 angeordnet. Diese ermöglicht eine dichtende Verbindung zwischen dem ersten Kammerabschnitt 4 und dem zweiten Kammerabschnitt 5, wie dies in Fig. 2 dargestellt ist.

Unterhalb des porösen Trägers 7 und seitlich innerhalb des ringförmigen Justierungsmarkenstempels 9 ist ein sich nahezu über die gesamte Flächenausdehnung des Trägers 7 erstreckender Hohlraum 24 vorgesehen. Die Oberseite des Hohlraums 24 wird von dem porösen Träger 7 gebildet. Innerhalb des Hohlraums 24 sind eine Vielzahl beabstandeter Heizwendeln 25 angeordnet. Diese dienen zur späteren Aushärtung des auf den Justierungsmarkenstempel 9 aufgebrachten PDMS 27 sowie zur Aushärtung des auf den Träger 7 über die Düse 11 aufgebrachten PDMS 12.

In den Hohlraum 24 mündet eine erste Vakuumleitung 26, mit der ein Unterdruck in dem Hohlraum 24 erzeugbar ist. Dieser Unterdruck wirkt auf den porösen Träger 7, wodurch eine Teilmenge des auf diesen aufgebrachten PDMS 12 sowie eine Teilmenge des auf den Justierungsmarkenstempel 9 aufgebrachten PDMS 27 in die Poren des starren Trägers eingesaugt werden kann.

Oberhalb des Masterstempels 17 ist in den ersten Kammerabschnitt 4 eine umlaufende Ringnut 28 eingebracht. In diese mündet eine zweite Vakuum-/Druckleitung 29. Über die Leitung 29 ist sowohl ein Unterdruck als auch ein Überdruck auf der dem Träger 7 abgewandten Seite 30 erzeugbar. Bei dem Anlegen eines Unterdrucks wird der Masterstempel 17 in dem ersten Kammerabschnitt 4 gehalten. Bei Herstellung von Normaldruck oder bei Beaufschlagung des Bereichs hinter der Seite 30 des Masterstempels 17 mit Überdruck bewegt sich der Masterstempel 17 translatorisch in Richtung des starren Trägers 7.

In die Ringnut 28 münden zwei beabstandete Messeinrichtungen 31, 32, mit denen die Position des Masterstempels 17 und damit der Abstand zwischen der Nanostrukturoberfläche 18 des Masterstempels 17 und dem Träger 7 bestimmbar ist.

Mit Abstand zu der zweiten Vakuum-/Druckleitung 29 ist eine dritte Vakuum-/Druckleitung 33 angeordnet, die in einen Bereich zwischen dem Masterstempel 17 und dem Träger 7 mündet. Beide Vakuum-/Druckleitungen 29, 33 sind seitlich durch die Umfangswand 19 des ersten Kammerabschnitts 4 geführt. Mittels der dritten Vakuum-/Druckleitung 33 kann ein Unterdruck und/oder ein Überdruck in dem Bereich zwischen dem Masterstempel 17 und dem Träger 7 erzeugt werden.

Oberhalb des Masterstempels 17 ist innerhalb des ersten Kammerabschnitts 4 ein zweiter Hohlraum 34 eingebracht. In diesem zweiten Hohlraum 34 befinden sich mehrere beabstandete Heizwendeln 35 zur Aushärtung des aufgebrachten PDMS.

In Fig. 2 ist die aus dem ersten Kammerabschnitt 4 und dem zweiten Kammerabschnitt 5 gebildete Kammer 36 geschlossen und gegenüber der Atmosphäre/Umgebung über die Ringdichtung 23 abgedichtet.

Beide Düsen 11, 15 mit ihren Leitungen 13, 16 sind aus dem Bereich innerhalb der Kammer 36 heraus geschwenkt. Über die Vakuumleitung 26 ist ein Vakuum an den Hohlraum 24 angelegt, wodurch eine Teilmenge 37 des auf den Träger 7 aufgebrachten PDMS 12 in die Poren des Trägers 7 eingesaugt wird. Weiterhin ist eine Teilmenge 38 des auf den Justierungsmarkenstempel 9 aufgebrachten PDMS 27 in die Poren des Trägers 7 eingesaugt.

An der zweiten Vakuum-/Druckleitung 29 liegt Normaldruck an. Der Masterstempel ist bis auf den Träger 7 translatorisch aufgefahren, wobei die Position des Masterstempels über die Messeinrichtungen 31, 32 bestimmt wird. Die dritte Vakuum-/Druckleitung 33 hat in dem in Fig. 2 dargestellten Zustand keine Funktion mehr. Die Leitung 33 wird von der Umfangsseite des Masterstempels 17 abgedichtet.

Im Folgenden wird das Verfahren zur Herstellung des Stempels erläutert.

Zunächst sind die beiden Kammerabschnitte 4, 5, wie in Fig. 1 gezeigt, geöffnet. Nun wird über die Düse 15 PDMS 27 auf die mit Justierungsmarkenstrukturen 10 versehene Oberseite 10 des ringförmigen Justierungsmarkenstempels 9 aufgebracht. Daraufhin wird der poröse Träger 7 auf den mit PDMS 27 beschichteten ringförmigen Justierungsmarkenstempel 9 aufgelegt. Hierdurch wird unterhalb des Trägers 7 ein geschlossener Hohlraum gebildet. Daraufhin wird die Oberseite 14 des Trägers 7 über die Düse 11 und daran anschließende Leitung 13 mit flüssigem PDMS 12 beschichtet.

In dem darauf folgenden Schritt werden die Düsen 11, 15 mit den dazugehörigen Leitungen 13, 16 aus dem Bereich zwischen dem ersten Kammerabschnitt 4 und dem zweiten Kammerabschnitt 5 herausgeschwenkt.

Daraufhin erfolgt das Schließen der Kammer 36 durch Verschwenken des ersten Kammerabschnitts 4 um das Schwenkgelenk 6. Hierzu kann ein nicht dargestellter motorischer Antrieb vorgesehen sein. Die Umfangswand 10 des ersten Kammerabschnitts 4 liegt auf der Umfangswand 22 des zweiten Kammerabschnitts 5 auf. Die Abdichtung erfolgt über die Ringdichtung 23 auf der Oberseite 21 der Umfangswand 22 des zweiten Kammerabschnitts 5.

An der zweiten Vakuum-/Druckleitung 29 ist ein Vakuum angelegt, um den Masterstempel 17 in der in Fig. 1 dargestellten oberen Position zu halten. Nach einer vorgegebenen Zeit wird an die Leitungen 26, 33 ebenfalls Vakuum angelegt. Durch die Beaufschlagung des Hohlraums 24 über die Vakuumleitung 26 mit Unterdruck wird eine Teilmenge 37 des PDMS 12 sowie eine Teilmenge 38 des PDMS 27 in die Poren des starren Trägers 7 eingesaugt. Das PDMS haftet somit innerhalb des Stempelmaterials.

Nach einer einstellbaren Evakuierungszeit wird die zweite Vakuum-/Druckleitung 29 dem atmosphärischen Druck ausgesetzt. Zu einem späteren Zeitpunkt wird auch die dritte Vakuum-/Druckleitung 33 des atmosphärischen Druck ausgesetzt. Der Masterstempel 17 wandert in Richtung auf den Träger 7 zu, wobei die Nanostrukturoberfläche 18 in das auf der Oberseite 14 des Trägers 7 befindliche PDMS 12 eintaucht. Bevorzugt fährt der Masterstempel 17 bis an den Träger 7 heran, um eine möglichst dünne Nanostempelstruktur aus PDMS zu erhalten. Die Position des Masterstempels 17 wird über die Messeinrichtungen 31, 32 bestimmt. Das Messergebnis dient als Steuergröße für eine nicht dargestellte Bewegungssteuereinheit, die auch die Beaufschlagung der Vakuum-/Druckleitungen 26, 29 und 33 steuert. Durch das Eintauchen der Nanostrukturoberfläche 18 des Masterstempels 17 in das flüssige PDMS 12 wird die Nanostruktur ohne Blasenbildung in das flüssige PDMS 12 auf der Oberseite 14 des Trägers 7 übertragen. Gleichzeitig wird überschüssiges PDMS 37 in den porösen Träger 7 eingesaugt. Nach dem Einsaugen der gewünschten Menge an PDMS 37 in den starren Träger 7 und/oder nach Erreichen einer vorgegebenen Position des Masterstempels 17 beginnt der Aushärteprozess mittels der Heizwendel 25, 35. Hierdurch härtet die Nanostempelstruktur 3 aus PDMS sowie die Justierungsmarken 39 auf der der Nanostempelstruktur 3 gegenüberliegenden Seite des Trägers 7 aus. Durch die gleichzeitige Aushärtung wird eine definierte Zuordnung der Justierungsmarken 39 zu der Nanostempelstruktur 3 erreicht.

Nach dem Aushärteprozess wird der erste Kammerabschnitt 4 um das Gelenk 6 in Öffnungsstellung verschwenkt, woraufhin der fertige Stempel, bestehend aus Träger 7, Nanostempelstruktur 3 sowie Justierungsmarken 39 entnommen werden kann.

Die Vorrichtung ist nun bereit zur Herstellung eines weiteren, großflächigen Nanostrukturstempels.

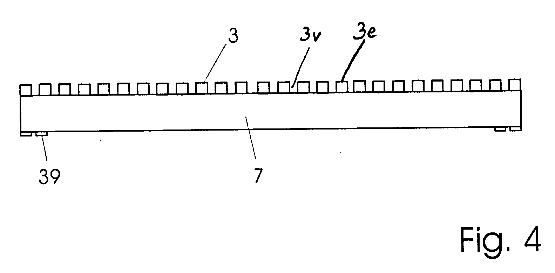

In Fig. 4 ist ein erfindungsgemäßer, großflächiger Stempel 2 mit einer erhabene Strukturen 3e sowie den erhabenen Strukturen 3e benachbarte Vertiefungen 3v aufweisenden Nanostempelstruktur 3, einem porösen Träger 7 sowie mit Justierungsmarken 39 gezeigt. Die Oberseite und die Unterseite des Stempels 2 sind eben parallel ausgebildet.

### Bezugszeichenliste

- 1: Vorrichtung
- 2: Stempel
- 3: Nanostempelstruktur
- 3e: Erhabene Strukturen
- 3v: Vertiefungen
- 4: erster Kammerabschnitt
- 5: zweiter Kammerabschnitt
- 6: Schwenkgelenk
- 7: Träger
- 8: Randbereich
- 9: Justierungsmarkenstempel
- 10: Justierungsmarkenstruktur
- 11: erste Düse (erstes Aufbringmittel)
- 12: PDMS
- 13: Zuleitung
- 14: Oberseite des Trägers
- 15: zweite Düse (zweites Aufbringmittel)
- 16: Zuleitung
- 17: Masterstempel
- 18: Nanostrukturoberfläche
- 19: Umfangswand
- 20: O-Ringe
- 21: Oberseite
- 22: Umfangswand
- 23: Ringdichtung
- 24: Hohlraum
- 25: Heizwendel
- 26: erste Vakuumleitung
- 27: PDMS
- 28: Ringnut
- 29: zweite Vakuum-/Druckleitung
- 30: Seite
- 31: Messeinrichtung
- 32: Messeinrichtung
- 33: dritte Vakuum-/Druckleitung
- 34: zweiter Hohlraum
- 35: Heizwendel
- 36: Kammer
- 37: Teilmenge
- 38: Teilmenge
- 39: Justierungsmarken

## Patentansprüche

1. Vorrichtung zur Herstellung eines Stempels (2) mit einer Nanostempelstruktur (3), wobei die Vorrichtung (1) folgende Bauteile umfasst:
• ein Aufnahmemittel (5) zur Aufnahme eines starren Trägers (7);
• mindestens einen relativ zu dem starren Träger (7) bewegbaren Masterstempel (17) mit einer Nanostrukturoberfläche (18);
• mindestens ein Aufbringmittel (11) zum Aufbringen eines fließfähigen, aushärtbaren Polymers, insbesondere eines Elastomers, vorzugsweise eines Siloxans, bevorzugt von Poly-Dimethyl-Siloxans (PDMS) (12), auf den Träger (7),
wobei mittels der Vorrichtung erhabene Strukturen (3e) sowie den erhabenen Strukturen (3e) benachbarte Vertiefungen (3v) durch die korrespondierend ausgebildete Nanostrukturoberfläche (18) aufbringbar sind, und die Nanostrukturoberfläche (18) unmittelbar an den mit dem Polymer beaufschlagten starren Träger (7) heranführbar ausgestaltet ist, **dadurch gekennzeichnet, dass** mindestens ein Justierungsmarkenstempel (9) zum Einbringen einer dreidimensionalen Justierungsmarke (39) in die von dem Masterstempel (17) abgewandte Seite des Trägers (7) während der Herstellung der Nanostempelstruktur (3) vorgesehen ist.

2. Vorrichtung nach Anspruch 1,
**dadurch gekennzeichnet, dass**
eine abdichtbare Kammer (36) für den Masterstempel (17) und den starren Träger (7) mit einer Umfangswand (19, 22) vorgesehen ist.

3. Vorrichtung nach einem der Ansprüche 1 oder 2,
**dadurch gekennzeichnet, dass**
die Seite (14) des Trägers (7), auf die die Nanostempelstruktur (3) aufgebracht wird, parallel zu der Nanostrukturoberfläche (18) des Masterstempel (17) anordenbar ist, vorzugsweise derart, dass der Masterstempel (17) über dem starren Träger (7) angeordnet ist und die Nanostrukturoberfläche (18) des Masterstempels (17) nach unten in Richtung des starren Trägers (7) gerichtet ist.

4. Vorrichtung nach einem der Ansprüchen 1 bis 3,
**dadurch gekennzeichnet, dass**
der Masterstempel (17) innerhalb der Kammer (36) translatorisch auf den Träger (7) zu, vorzugsweise bis zum Träger (7), bewegbar ist.

5. Vorrichtung nach einem der Ansprüche 1 bis 4,
**dadurch gekennzeichnet, dass**
eine oder mehrere Messeinrichtung(en) (31, 32) zur Messung der Position des Masterstempels (17) und/oder des Trägers (7) vorgesehen ist.

6. Vorrichtung nach einem der Ansprüche 1 bis 5,
**dadurch gekennzeichnet, dass**
mindestens eine erste Vakuumleitung (26) zum Anlegen eines Vakuums an den zumindest in einem Teilbereich aus porösem und/oder mit Kanälen durchzogenen Material bestehenden Träger (7) von der dem Masterstempel (17) abgewandten Seite des Trägers (7) her vorgesehen ist.

7. Vorrichtung nach einem der Ansprüche 1 bis 6,
**dadurch gekennzeichnet, dass**
mindestens eine Aushärteinrichtung (25, 35), vorzugsweise eine Heizung (25, 35), zur Aushärtung der Nanostempelstruktur (3) und/oder der dreidimensionalen Justierungsmarken (39) vorgesehen ist.

8. Verfahren zur Herstellung eines Stempels (2),
**dadurch gekennzeichnet, dass**
das Verfahren folgende Verfahrensschritte umfasst:
• Aufbringen eines fließfähigen, aushärtbaren Polymers, insbesondere eines Elastomeres, vorzugsweise eines Siloxans, bevorzugt von Poly-Dimethyl-Siloxans (PDMS) (12) auf einen starren Träger (7);
• Verringerung des Abstandes zwischen einem eine Nanostrukturoberfläche (18) aufweisenden Masterstempel (17) und dem starren Träger (7) und dadurch Einbringen der Nanostruktur des Masterstempels (17) in das fließfähige Polymer (12) zur Erzeugung einer Nanostempelstruktur (3) mit erhabenen Strukturen (3e) und den erhabenen Strukturen (3e) benachbarten Vertiefungen (3v) bis zur Kontaktierung von erhabenen Strukturen des Masterstempels (17) mit dem starren Träger (7);
• Aushärten des Polymers (12),
**dadurch gekennzeichnet, dass**
eine dreidimensionale Justierungsmarke (39) in den Träger (7) eingebracht wird, wobei die dreidimensionalen Justierungsmarken (39) und die Nanostempelstruktur (3) gleichzeitig ausgehärtet werden.

9. Verfahren nach Anspruch 8,
**dadurch gekennzeichnet, dass**
ein Vakuum an den zumindest in einem Teilbereich aus porösem Material bestehenden und/oder mit Kanälen durchzogenen Träger (7) angelegt wird und dadurch eine Teilmenge (37) des Polymers (12) in den Träger (7) eingesaugt wird.

10. Verfahren nach einem der Ansprüche 8 oder 9,
**dadurch gekennzeichnet, dass**
die dreidimensionale Justierungsmarke (39) in den Träger (7), nämlich in die dem Masterstempel (17) abgewandte Seite des Trägers (7), eingebracht wird, insbesondere während der Herstellung der Nanostempelstruktur (3).

## Claims

1. Device for the production of a stamp (2) with a nanostamping structure (3), wherein the device (1) includes the following structural parts:
• a receiving means (5) for receiving a rigid support (7);
• at least one master stamp (17) with a nanostructure surface (18), movable relative to the rigid support (7);
• at least one application means (11) for applying a flowable, hardenable polymer, in particular an elastomer, preferably a siloxane and specifically polymer(dimethylsiloxane) (PDMS) (12) to the support (7), wherein by means of the device raised structures (3e) as well as depressions (3v) adjacent to the raised structures (3e) can be applied via the correspondingly configured nanostructure surface (18) and the nanostructure surface (18) is designed so that it can be driven directly up to the rigid support (7) which is provided with the polymer, **characterised in that** at least one adjustment marker stamp (9) is provided for introducing a three-dimensional adjustment marker (39) into the side of the support (7) facing away from the master stamp (17) during the production of the nanostamping structure (3).

2. Device according to claim 1, **characterised in that** a sealable chamber (36) for the master stamp (17) and the rigid support (7) is provided with a circumferential wall (19, 22).

3. Device according to one of claims 1 and 2, **characterised in that** the side (14) of the support (7) on which the nanostamping structure (3) is applied can be arranged parallel to the nanostructure surface (18) of the master stamp (17), preferably in such a way that the master stamp (17) is arranged above the rigid support (7) and the nanostructure surface (18) of the master stamp (17) is aligned downwardly in the direction of the rigid support (7).

4. Device according to one of claims 1 to 3, **characterised in that** the master stamp (17) can be moved within the chamber (36) in a translational manner to the support (7), preferably up to the support (7).

5. Device according to one of claims 1 to 4, **characterised in that** one or more measuring devices (31, 32) is/are provided for measuring the position of the master stamp (17) and/or of the support (7).

6. Device according to one of claims 1 to 5, **characterised in that** at least a first vacuum line (26) for applying a vacuum to the support (7) consisting at least in a partial region of porous material and/or material penetrated by channels, is provided on the side of the support (7) facing away from the master stamp (17).

7. Device according to one of claims 1 to 6, **characterised in that** at least one hardening device (25, 35), preferably a heating means (25, 35), is provided for hardening the nanostamping structure (3) and/or the three-dimensional adjustment markers (39).

8. Method for producing a stamp (2), **characterised in that** the method comprises the following process steps:
• application of a flowable, hardenable polymer, in particular an elastomer, preferably a siloxane, specifically poly(dimethylsiloxane) (PDMS) (12) to a rigid support (7);
• reducing the distance between the master stamp (17) having a nanostructure surface (18) and the rigid support (7) and thereby introducing the nanostructure of the master stamp (17) into the flowable polymer (12) to produce a nanostamping structure (3) with raised structures (3e) and depressions (3v) adjacent to the raised structures (3e), until contacting of the master stamp (17) with the rigid support (7);
• hardening the polymer (12),
**characterised in that** a three-dimensional adjustment marker (39) is introduced into the support (7), wherein the three-dimensional adjustment markers (39) and the nanostamping structure (3) are simultaneously hardened.

9. Method according to claim 8, **characterised in that** a vacuum is applied to the support (7) consisting at least in a partial region of porous material and/or that is penetrated by channels, a partial amount (37) of the polymer (12) thereby being aspirated into the support (7).

10. Method according to one of claims 8 and 9, **characterised in that** a three-dimensional adjustment marker (39) is introduced into the support (7), namely into the side of the support (7) facing away from the master stamp (17), in particular during production of the nanostamping structure (3).

## Revendications

1. Dispositif de fabrication d'un poinçon (2) comprenant une structure de nano-poinçon (3), dans lequel le dispositif (1) comprend les pièces suivantes :
- un moyen de réception (5) pour recevoir un support rigide (7) ;
- au moins un poinçon-maître (17) mobile par rapport au support rigide (7) comprenant une surface de nano-structure (18) ;
- au moins un moyen d'application (11) pour appliquer un polymère fluide durcissable, en particulier un élastomère, de préférence un siloxane, de manière préférée du polydiméthylsiloxane (PDMS) (12), sur le support (7),
sachant que des structures en relief (3e) ainsi que des creux (3v) voisins des structures en relief (3e) peuvent être appliqués à travers la surface de nano-structure (18) formée de manière correspondante, au moyen du dispositif, et
la surface de nana-structure (18) est formée en pouvant être dirigée directement contre le support rigide (7) recevant le polymère,
**caractérisé en ce**
**qu'**au moins un poinçon de repère de réglage (9) pour marquer un poinçon de repère (39) tridimensionnel est prévu dans le côté du support (7) détourné du poinçon-maître (17) pendant la fabrication de la structure de nano-poinçon (3).

2. Dispositif selon la revendication 1,
**caractérisé en ce**
**qu'**une chambre pouvant être étanchéifiée (36) pour le poinçon-maître (17) et le support rigide (7), est dotée d'une paroi périphérique (19, 22).

3. Dispositif selon la revendication 1 ou 2,
**caractérisé en ce que**
le côté (14) du support (7) sur lequel la structure de nano-poinçon (3) est appliquée, peut être agencé parallèlement à la surface de nano-structure (18) du poinçon-maître (17), de préférence de telle façon que le poinçon-maître (17) soit disposé au-dessus du support rigide (7) et que la surface de nano-structure (18) du poinçon-maître (17) soit dirigée vers le bas en direction du support rigide (7).

4. Dispositif selon l'une des revendications 1 à 3,
**caractérisé en ce que**
le poinçon-maître (17) est mobile en translation en direction du support (7), de préférence jusqu'au support (7), dans la chambre (36).

5. Dispositif selon l'une des revendications 1 à 4,
**caractérisé en ce**
**qu'**un ou plusieurs dispositif(s) de mesure (31, 32) pour mesurer la position du poinçon-maître (17) et/ou du support (7) est/sont prévu(s).

6. Dispositif selon l'une des revendications 1 à 5,
**caractérisé en ce**
**qu'**au moins une première ligne de vide (26) est prévue pour appliquer un vide sur le support (7) composé, au moins dans une partie, d'un matériau poreux et/ou traversé par des canaux, depuis le côté du support (7) détourné du poinçon-maître (17).

7. Dispositif selon l'une des revendications 1 à 6,
**caractérisé en ce**
**qu'**au moins un dispositif de durcissement (25, 35), de préférence un chauffage (25, 35), est prévu pour le durcissement de la structure de nano-poinçon (3) et/ou des repères de réglage (39) tridimensionnels.

8. Procédé de fabrication d'un poinçon (2),
**caractérisé en ce que**
le procédé comprend les étapes de procédé suivantes :
- application d'un polymère fluide durcissable, en particulier un élastomère, de préférence un siloxane, de préférence du polydiméthylsiloxane (PDMS) (12), sur un support rigide (7) ;
- réduction de l'écartement entre un poinçon-maître (17) présentant une surface de nano-structure (18) et le support rigide (7) et introduction ainsi de la nanostructure du poinçon-maître (17) dans le polymère fluide (12) pour produire une structure de nano-poinçon (3) avec des structures en relief (3e) et des creux (3v) voisins des structures en relief (3e) jusqu'à ce que les structures en relief du poinçon-maître (17) soient en contact avec le support rigide (7) ;
- durcissement du polymère (12),
**caractérisé en ce**
**qu'**un repère de réglage tridimensionnel (39) est intégré dans le support (7), sachant que les repères de réglage tridimensionnels (39) et la structure de nano-poinçon (3) sont durcis en même temps.

9. Procédé selon la revendication 8,
**caractérisé en ce**
**qu'**un vide est appliqué sur le support (7) composé, au moins dans une partie, d'un matériau poreux et/ou traversé par des canaux et qu'ainsi une quantité partielle (37) du polymère (12) soit aspirée dans le support (7).

10. Procédé selon la revendication 8 ou 9,
**caractérisé en ce que**
le repère de réglage tridimensionnel (39) est intégré dans le support (7), à savoir dans le côté du support (7) détourné du poinçon-maître (17), en particulier pendant la fabrication de la structure de nana-poinçon (3).
